(19) Europäisches Patentamt
European Patent Office
Office européen des brevets

(11) Publication number: 0 246 785
B1

(12) # EUROPEAN PATENT SPECIFICATION

(45) Date of publication of the patent specification: 28.02.90

(51) Int. Cl.[5]: C 30 B 25/14, B 01 J 4/00

(21) Application number: 87304105.7

(22) Date of filing: 08.05.87

(54) **Reagent source.**

(30) Priority: 21.05.86 GB 8612402

(43) Date of publication of application:
25.11.87 Bulletin 87/48

(45) Publication of the grant of the patent:
28.02.90 Bulletin 90/09

(84) Designated Contracting States:
AT BE CH DE ES FR GB GR IT LI LU NL SE

(56) References cited:
EP-A-0 175 030
EP-A-0 175 601
DE-A-1 947 463

SOLID STATE DEVICES 1982, ESSDERC-SSSDT MEETING, Munich, 13th-16th September 1982, pages 51-72, editor A. Goetzberger et al., Weinheim DE; J. HALLAIS: "Metal organic vapour phase epitaxy: the key issues

Idem

Journal of the Chem. Society, Faraday Transactions, Volume 10, 1974,pages 2267-2279

(73) Proprietor: BRITISH TELECOMMUNICATIONS public limited company
81 Newgate Street
London EC1A 7AJ (GB)

(72) Inventor: Moss, Rodney Hollands
46 Princes Road
Felixstowe Suffolk, IP11 7QZ (GB)
Inventor: Bradley, Donald Charlton
9 Scott Grove
Pinner Middlesex HA5 4RT (GB)
Inventor: Faktor, Marc Marian
Flat 2
14 Clorane Gardens London NW3 7PR (GB)
Inventor: Frigo, Dario Marcello
100b Galford Street
Kentish Town London NW5 2EH (GB)

(74) Representative: Leng, Francis Edward
British Telecom Intellectual Property Unit Room 1304
151 Gower Street
London WC1E 6BA (GB)

EP 0 246 785 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convension).

LIBERGRAF, STOCKHOLM 1990

## Description

This invention relates to a reagent source and more particularly to the provision at a controlled mass flow rate of a reagent, e.g. an organo-metallic reagent, into metal organic vapour phase epitaxy (which is conveniently abbreviated to MOVPE).

MOVPE is a widely used process to grow semiconductor layers onto semiconductor substrates. The growth is achieved by passing (cold) gaseous reactants in an inert gas stream over a hot, e.g. 600° - 800°, exposed surface of a substrate. The reaction occurs in contact with the hot surface and the product is deposited in the form of a single crystal. Some examples of epitaxy reactions, i.e. the overall reaction which occurs on the hot surface, include:

(1) $In(R')_3$ with $PH_3$ to give InP
(2) $Ga(R')_3$ with $AsH_3$ to give GaAs
(3) $Al(R')_3$ with $AsH_3$ to give AlAs

wherein R' is an alkyl group, eg an alkyl group with 1 to 5 carbon atoms such as ethyl or, particularly, methyl.

It is conventional to produce mixed systems by operating a plurality of reactions simultaneously and to achieve the necessary flexibility. It is standard practice to utilise separate and independant supply systems for each of the reactants and the inert gases. Some of the reagents, e.g. $PH_3$ and $AsH_3$, are gases and accurate devices, eg mass flow controllers are available to control the flow rate of a gas. The organo-metallic reagent is usually a metal alkyl, eg one or more of the trialkyls identified above. These are either volatile solids or volatile liquids and controlling the supply of these is more difficult.

Liquid and solid reagents are usually supplied into MOVPE by the entrainment method. This comprises passing a stream of gas over a solid or bubbling it through a liquid. The vapour pressure is an important control parameter and, because vapour pressure is strongly temperature dependent, even very accurate thermostats provide at best only adequate control. Other sources of error include variations in the efficiency of pick-up and the effect of flow-rate.

A modified entrainment method has been proposed (J. Chem. Soc., Faraday Trans. (1974) *70*, 2267 by Battat, Faktor, Garrett and Moss). This method still utilises the evaporation of a solid or a liquid but the rate of supply is controlled by a diffusive resistance. The inclusion of the resistance substantially enhances the accuracy but it also limits the supply rate whereby the modified entrainment is not generally applicable to MOVPE.

There are disadvantages associated with the alkyls (and particularly with trimethyl indium). Thus the alkyls are liable to spontaneous ignition and they may undergo other undesirable reactions during transport in the MOVPE. To reduce these disadvantages it has been proposed to form adducts or complexes of the metal alkyls. Thus a compound known as "diphos":

$(C_6H_5)_2PC_2H_4P(C_6H_5)_2$

forms a solid adduct with the metal alkyl, eg with trimethyl indium. The mole ratio is 2:1 since one metal alkyl attaches itself to each phosphorous atom. The diphos adduct is much safer and more convenient to handle and the formation of the adduct can also be used as an extra purification stage. It has also been proposed to use other adducts, e.g. amine complexes, of metal alkyls in the gas stream which supplies reagents into the MOVPE reaction chamber in order to suppress undesired reactions during transport. On heating, an amine complex dissociates to give the metal alkyl and the amine. The metal alkyl participates as usual in the MOVPE growth while the amine passes to waste without affecting the growth.

According to this invention, which is defined in the claims, a gaseous phase complexing agent is caused to diffuse, at a controlled rate, into the presence of the primary source. The complexing agent reacts with the primary source to form a gaseous phase complex which is conveyed into the process. The partial vapour pressure of the complexing agent is kept low. Under these conditions it has been found possible to supply adequate amounts of reagent into the process and to control accurately the rate of the supply.

Since this process uses adducts it not only provides the accurate control which is needed but it also takes advantage of the good properties associated with adducts.

The invention will be further described with reference to the accompanying drawings in which:

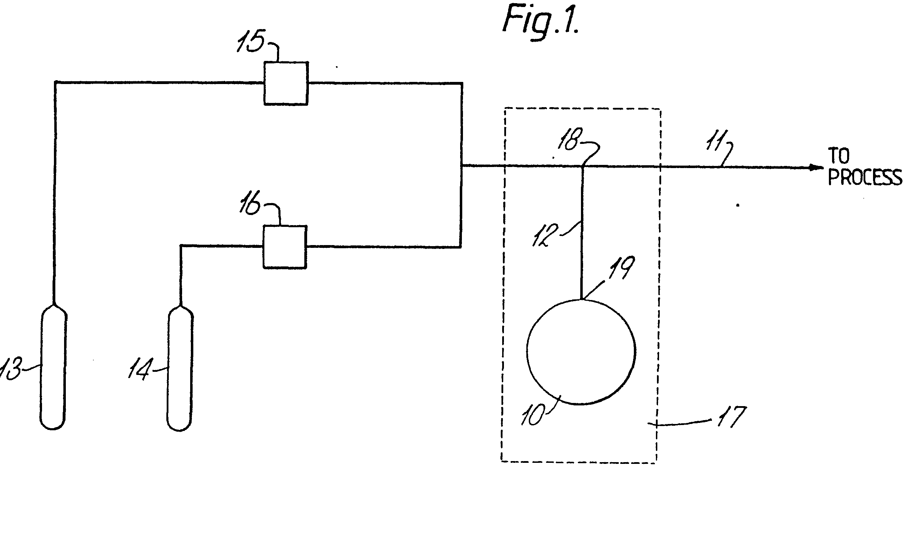

- Figure 1 is a diagrammatic illustration of a source according to the invention.

Figure 1 illustrates a source according to the invention which source is designed to provide a vapour phase organo-metallic reagent into a process such as organo-metallic vapour phase epitaxy and to control this supply to a constant mass-rate. The method uses a solid phase complexing agent and a gaseous phase complexing agent. To generalise: the organo-metallic compound will be represented as X, the solid phase complexing agent will be represented as A and the gaseous phase complexing agent as B. A carrier gas, eg helium, is also used. The two complexes will be represented as AX and BX (but the mole ratios of A : X and B : X are to be taken as unspecified). It is emphasised that, at the temperatures and pressures of operation, the molecular species A and AX are solid while the species B and BX are gaseous. The temperature and pressure are chosen so that these conditions apply.

The overall reaction used by the invention is the deplacement

$$AX + B = BX + A$$

but this may occur in two separate reactions:

(1) AX = A + X
(2) X + B = BX

The equilibrium constants are chosen so that at equilibrium, reaction (1) gives a higher vapour pressure of X than reaction (2).

This implies that, in the vapour phase, the partial pressures of X and B will be substantially zero.

The preferred species are:

X = $Me(R')_3$
A = $(C_6H_5)_2P\text{-}C_2H_4\text{-}P(C_6H_5)_2$
B = $N(R'')_3$
AX = $[(C_6H_5)_2P\text{-}C_2H_4\text{-}P(C_6H_5)_2][Me(R')_3]_2$
BX = $[N(R'')_3][Me(R')_3]$

wherein

Me is selected from In, Ga and Al;
R' is selected from alkyl groups with 1 to 5 carbon atoms, e.g. ethyl and, especially methyl; and
R'' is selected from alkyl groups with 1 to 5 carbon atoms, e.g. ethyl and, especially methyl.

As shown in Figure 1 the source apparatus comprises a reservoir 10 which contains the solid participants A and AX. The solid complex AX was placed in reservoir 10 before starting and it is connected into solid phase complexing agent A during use.

The reservoir 10 is connected to a gas line 11 by means of a capillary tube 12. The gas line 11 is supplied from bottles 13 and 14 with mass flow controllers 15 and 16. Bottle 13 conveniently contains a mixture of carrier gas and B, e.g. a mixture which contains 8 - 10 mole-% of B. Bottle 14 contains pure inert gas.

The mass flow controllers 15 and 16 provide accurate control of the flow rate and hence they provide accurate control of the concentration of B in carrier gas in the line 11. It will be noted that the reservoir 10 and capillary 11 form a conventional effusion cell in which the rate of diffusion through capillary 12 constitutes the important control parameter. Since diffusion is temperature dependant the reservoir 10 and capillary 12 are located in a thermostat 17. Since the diffusion is only weakly temperature dependent the control is accurate. This arrangement also ensures a suitable reaction temperature.

The following sizes, which are quoted by way of example only, have been found suitable for the reservoir 10 and the capillary 12:

| | |
|---|---|
| Capacity of reservoir 10 | 50 cc |
| Length of capillary 12 | 40 mm |
| Diameter of capillary 12 | 4 mm |

The equipment also includes joints (not shown) to permit assembly and dis-assembly, eg for replenishment of solid complex AX in the reservoir 10.

The control mechanism established by the system described above will now be considered. The hypothetical initial state for this explanation is reservoir 10 containing inert gas in equilibrium with solid complex AX at the temperature of thermostat 17. The gas line 11 contains a stream of inert gas and gaseous phase complexing agent B at a controlled concentration fixed by the mass flow controllers 15 and 16.

In this initial state, gaseous phase complexing agent B will diffuse into capillary 12 and thereby establish a partial pressure gradient from the primary end 18 to the secondary end 19 where the partial pressure of the gaseous phase complexing agent B is effectively zero. When B enters the reservoir 10 it encounters organo-metallic X in the gas phase and it reacts to form gaseous phase adduct BX. This reaction has two effects. The first effect is that gaseous phase complexing agent B is substantially removed whereby its partial pressure in reservoir 10 remains substantially zero and the inlet diffusion conditions are substantially unaffected. The second effect is to reduce the partial pressure of organo-metallic X whereby further decomposition of solid adduct AX occurs.

The formation of BX means that its partial pressure in the reservoir 10 rises and hence its diffusion rate out of the reservoir 10 via capillary 12 also rises. Eventually a steady state is established in which the outflow of gaseous phase complex BX matches the inflow of complexing agent B and the partial pressure of gaseous adduct BX in the reservoir 10 achieves a steady state at the level appropriate for this match.

The steady state conditions in the reservoir 10 should also considered. The vapour pressure of organo-metallic X is depressed below the equilibrium with primary adduct AX. The result is that the rate of decomposition of AX is matched to the inflow of B.

It is emphasised that the diffusion rate of gaseous complexing agent B is controlled by its partial pressure at the primary end 18 of the capillary 12 and not by the flow rate of the mixture. Within the operational range, altering the flow rate only alters the amount of the excess but it does not change the partial pressure and hence it does not alter the rate of diffusion.

The two bottles 13 and 14 and the two mass flow controllers 15 and 16 are needed so as to change the ratio of the two flows. This changes the partial pressue of gaseous complexing agent B in the gas stream which also changes its rate of diffusion from primary end 18 to secondary end 19. All other steady state conditions will be changed to match the changed diffusion rate. The changes consequent upon a higher partial pressure will now be considered. Four control mechanisms can be distinguished.

(1) The higher partial pressure of agent B at primary end 18 causes an increase in the rate of diffusion through capillary 12.
(2) The increased rate of (1) increases the rate of

formation of gaseous complex BX.

(3) The increased rate of formation of secondary complex BX, ie item (2) above, increases the partial pressure of gaseous complex BX.

(4) The increased partial pressure of BX increases the rate of diffusion of BX out of the reservoir 10. The rate of diffusion-out of BX stabilises when it matches the rate of diffusion-in of B, ie item (1) above.

It is emphasised that the primary control is provided by item (1) above because all of items (2) to (4) adjust to item (1). It is therefore instructive to consider the three factors which influence the rate of diffusion.

*The diffusion resistance* of capillary 12 is clearly an important factor since short fat tubes will allow a faster rate than long thin tubes. In practice the tube is a fixed element and therefore the resistance is constant. A new or different tube 12 would require re-calibration.

*The temperature* of the diffusion path also affects the diffusion rate. Gases diffuse slower at higher temperatures and, therefore, the thermostat 17 is needed to provide a constant temperature. It is emphasised that diffusion is only weakly temperature dependant and at 100°C (a convenient working temperature) a thermostat error of one degree (± 1 °C) would cause an error in the diffusion rate of about ± 0.5 %. Therefore, with even a moderate quality thermostat, it is possible to control the diffusion process to a very good level of accuracy.

*The partial pressure gradient* of agent B applied to the capillary 12 is also a control parameter. Since the partial pressure of gaseous complexing agent B at the secondary end 19 is always very low it can be taken as zero, leaving the partial pressure at primary end 18 as the control parameter. As explained above, this partial pressure is conveniently controlled and adjusted by mass flow controllers 15 and 16.

The control process described above is considerably more accurate than the entrainment method described above because the strongly temperature dependent effect of vapour pressure is replaced by the weakly dependent effect of diffusion rate. Furthermore inaccuracies related to efficiency of pick-up are eliminated. The restrictions on supply rate, which are inherent in the modified entrainment method, are overcome because the secondary adduct is gaseous. Thus, even when the primary source is involatile or when it has a low decomposition pressure, adequate amounts of reagent will pass through the diffusive resistance.

The method of the invention utilises adducts and, therefore, it offers the advantages associated with these.

## Claims

1. A method of providing a reagent into a chemical process said provision being in the vapour phase and at a controlled mass flow rate herein the method comprises:

(a) providing a gas stream which contains a gaseous phase complexing agent for the reagent said complexing agent being provided at a controlled partial vapour pressure in said gas stream;

(b) providing a primary source of the reagent in a reservoir which is connected to the gas stream via a diffusion path;

(c) causing the gaseous phase complexing agent to diffuse into the reservoir at a mass flow rate controlled by its partial pressure in the gas stream;

(d) causing the gaseous phase complexing agent in the reservoir to react with the primary source to generate a gaseous phase complex of the reagent and the gaseous phase complexing agent, said generation being, in the steady state, at a rate equivalent to the rate of inflow of said complexing agent;

(e) causing the gaseous phase complex to diffuse out of the reservoir into the gas stream at a rate, in the steady state, which is equivalent to its rate of generation in stage (d);

whereby the mass flow of reagent occurs at a rate defined and controlled by the vapour pressure of the gaseous phase complexing agent in the gas stream.

2. A method according to claim 1 in which the gas stream is provided from two sources with different concentrations of the gaseous phase complexing agent said sources being associated with flow control means adapted to adjust the flow ratio whereby the partial vapour pressure of the gaseous phase complexing agent in the gas stream is controlled.

3. A method according to claim 2, wherein each source has its own mass flow controller.

4. A method according to either claim 2 or claim 3, wherein one source is a mixture of carrier gas and gaseous phase complexing agent and the other source is pure carrier gas.

5. A method according to any one of the preceding claims, herein the diffusion path and the reservoir are thermostated to control the temperature and thereby provide a precisely defined diffusion rate.

6. A method according to any one of the preceding claims, wherein the primary source of the reagent is a solid adduct, being an adduct of the reagent and a solid adduct forming agent.

7. A method according to claim 6, which method is adapted to provide a metallo-organic reagent into an MOVPE process, wherein:

(a) the reagent is a metal alkyl selected from indium trialkyls, aluminium trialkyls and gallium trialkyls.

(b) the gaseous phase complexing agent is an amine.

8. A method according to claim 7 in which the primary source of the reagent is a diphos adduct of the metal alkyl.

9. A method according to either claim 7 or claim 8, wherein the gaseous phase complexing agent is trimethylamine.

10. A method according to an of claims 1 to 4, which method is adapted to provide an indium reagent into an MOVPE process at a controlled mass flow rate, herein the method comprises:

(a) providing a gas stream comprising a carrier gas and trimethylamine at controlled partial pressure;
(b) providing a solid adduct of indium trimethyl and diphos in a reservoir which is connected to the gas stream via a diffusion path, said reservoir and said path being thermostatically maintained at a temperature within the range 75°C and the melting point of diphos;
(c) causing the trimethylamine to diffuse into the reservoir at a mass flow rate controlled by its partial pressure in the gas stream;
(d) causing the trimethylamine in the reservoir to react with indium trimethyl vapour also in the reservoir to form trimethylamine/indium trimethyl complex;
(e) causing said amine complex to diffuse into the gas stream;

whereby the indium/amine complex is passed to the MOVPE process at a mass flow rate controlled by the partial vapour pressure of the trimethylamine in the gas stream.

**Patentansprüche**

1. Verfahren zum Zuführen eines Reagenz in einen chemischen Prozeß, wobei dieses Zuführen in der Dampfphase stattfindet und bei einer gesteuerten Masseflußrate, und wobei das Verfahren aufweist:

(a) Zuführen eines Gasstromes, der ein in der Gasphase komplexbildendes Agens für das Reagenz enthält, wobei das komplexbildende Agens bei einem gesteuerten Partialdampfdruck in dem Gasstrom zugeführt wird;
(b) Zuführen einer primären Quelle des Reagenz in einen Behälter, der mit dem Gasstrom über einen Diffusionsweg verbunden ist;
(c) Bewirken, daß das in der Gasphase komplexbildende Agens in den Behälter diffundiert, und zwar mit einer Masseflußrate, die durch dessen Partialdruck in dem Gasstrom gesteuert wird;
(d) Bewirken, daß das in der Gasphase komplexbildende Agens in dem Behälter mit der primären Quelle reagiert, um einen Komplex in der Gasphase aus dem Reagenz und dem in der Gasphase komplexbildenden Agens zu erzeugen, wobei diese Erzeugung bei einer Rate im Fließgleichgewicht ist, die äquivalent zu der Rate des Zufließens des komplexbildenden Agens ist;
(e) Bewirken, daß der Komplex in der Gasphase aus dem Behälter heraus in den Gasstrom mit einer Rate diffundiert, und zwar im Fließgleichgewicht, die äquivalent ist zu dessen Erzeugungsrate im Schritt (d);

wobei der Massenfluß des Reagenz mit einer Rate auftritt, die bestimmt und gesteuert wird mittels des Dampfdruckes des in der Gasphase komplexbildenden Agens in dem Gasstrom.

2. Verfahren nach Anspruch 1, bei dem der Gasstrom von zwei Quellen mit unterschiedlichen Konzentrationen des in der Gasphase komplexbildenden Agens zugeführt wird, wobei die Quellen mit Flußsteuereinrichtungen verbunden sind, die angepaßt sind, um das Flußverhältnis einzustellen, wodurch der Partialdampfdruck des in der Gasphase komplexbildenden Agens in dem Gasstrom gesteuert wird.

3. Verfahren nach Anspruch 2, wobei die Quelle ihre eigene Masseflußsteuereinheit hat.

4. Verfahren nach Anspruch 2 oder 3, wobei eine Quelle eine Mischung aus Trägergas und des in der Gasphase komplexbildenden Agens ist und die andere Quelle ein reines Trägergas ist.

5. Verfahren nach einem der vorhergehenden Ansprüche, wobei der Diffusionsweg und der Behälter thermostatgeregelt sind, um die Temperatur zu steuern, und dadurch eine genau definierte Diffusionsrate zu erzeugen.

6. Verfahren nach einem der vorhergehenden Ansprüche, wobei die primäre Quelle des Reagenz ein festes Addukt ist, das ein Addukt aus dem Reagenz und einem ein festes Addukt bildenden Agens ist.

7. Verfahren nach Anspruch 6, wobei das Verfahren angepaßt ist, um ein metallo-organisches Reagenz das dem MOVPE-Prozeß zuzuführen, wobei:

(a) das Reagenz ein Metallalkyl ist, das aus Indiumtrialkylen, Aluminiumtrialkylen und Galliumtrialkylen ausgewählt ist;
(b) das in der Gasphase komplexbildende Agens ein Amin ist.

8. Verfahren nach Anspruch 7, wobei die Primärquelle des Reagenz ein Diphosaddukt des Metallalkyls ist.

9. Verfahren nach Anspruch 7 oder 8, wobei das

in der Gasphase komplexbildende Agens Trimethylamin ist.

10. Verfahren nach einem der Ansprüche 1 bis 4, wobei das Verfahren angepaßt ist, ein Indium-Reagenz einem MOVPE-Prozeß mit einer gesteuerten Masseflußrate zuzuführen, wobei das Verfahren aufweist:

(a) Zuführen eines Gasstromes, der ein Trägergas und Trimethylamin bei gesteuertem Partialdruck aufweist;
(b) Zuführen eines festen Addukts aus Indiumtrimethyl und Diphos in einen Behälter, der mit einem Gasstrom über einen Diffusionsweg verbunden ist, wobei der Behälter und der Weg thermostatisch auf einer Temperatur gehalten werden, die innerhalb des Bereichs von 75 °C und dem Schmelzpunkt von Diphos liegt;
(c) Bewirken, daß Trimethylamin in den Behälter mit einer Masseflußrate diffundiert, die mittels dessen Partialdruck in dem Gasstrom gesteuert wird;
(d) Bewirken, daß Trimethylamin in dem Behälter mit Indiumtrimethyldampf, der ebenfalls in dem Behälter ist, reagiert, um einen Trimethylamin/Indium-Trimethyl-Komplex zu bilden;
(e) Bewirken, daß dieser Aminkomplex in den Gasstrom diffundiert;

wobei der Indium/Aminkomplex dem MOVPE-Prozeß mit einer Masseflußrate zugeführt wird, die durch den Partialdampfdruck des Trimethylamins in dem Gasstrom gesteuert wird.

## Revendications

1. Un procédé pour alimenter en réactif un traitement chimique, ladite alimentation étant réalisée en phase vapeur et selon un débit massique réglé, dans lequel le procédé comprend les étapes consistant à:

(a) amener un flux gazeux qui contient un agent complexant en phase gazeuse pour le réactif, ledit agent complexant étant amené à une pression de vapeur réglée dans ledit flux gazeux;
(b) amener une source primaire du réactif dans un réservoir qui est relié au flux gazeux par un trajet de diffusion;
(c) provoquer la diffusion de l'agent complexant en phase gazeuse dans le réservoir selon un débit massique réglé par sa pression partielle dans le flux gazeux;
(d) provoquer la réaction de l'agent complexant en phase gazeuse situé dans le réservoir avec la source primaire pour engendrer un complexe en phase gazeuse du réactif et de l'agent complexant en phase gazeuse, ladite génération étant, à l'état stable, à un débit équivalent au débit d'entrée de flux dudit agent complexant;
(d) provoquer la diffusion du complexant en phase gazeuse hors du réservoir dans le flux gazeux à un débit, à l'état stable, qui est équivalent à son débit de génération à l'état (d);

dans lequel le débit de réactif se produit selon un débit défini et réglé par la pression de vapeur de l'agent complexant en phase gazeuse dans le flux gazeux.

2. Un procédé selon la revendication 1 dans lequel le flux gazeux provient de deux sources à des concentrations différentes de l'agent complexant en phase gazeuse, lesdites sources étant associées à des moyens de réglage de débit aptes à ajuster le rapport de débit grâce à quoi la pression partielle de vapeur de l'agent complexant en phase gazeuse dans le flux gazeux est réglée.

3. Un procédé selon la revendication 2, dans lequel chaque source comporte son propre débitmètre massique.

4. Un procédé selon la revendication 2 ou la revendication 3, dans lequel une source est un mélange de gaz porteur et d'un agent complexant en phase gazeuse et l'autre source est un gaz porteur pur.

5. Un procédé selon l'une quelconque des précédentes revendications, dans lequel le trajet de diffusion et le réservoir sont thermostatés pour régler la température et réaliser ainsi un débit de diffusion défini précisément.

6. Un procédé selon l'une quelconque des précédentes revendications, dans lequel la source primaire du réactif est un additif solide, qui est un additif du réactif et d'un agent formant un additif solide.

7. Un procédé selon la revendication 6, procédé qui est apte à fournir un réactif organo-métallique par un processus d'épitaxie organométallique en phase vapeur ou EOMPV, dans lequel:

(a) le réactif est un alkyle métallique choisi parmi les trialkyles d'indium, les trialkyles d'aluminium et les trialkyles de gallium.
(b) l'agent complexant en phase gazeuse est une amine.

8. Un procédé selon la revendication 7 dans lequel la source primaire du réactif est un additif au diphos de l'alkyle métallique.

9. Un procédé selon la revendication 7 ou la revendication 8, dans lequel l'agent complexant en phase gazeuse est la triméthylamine.

10. Un procédé selon l'une quelconque des revendications 1 à 4, procédé qui est apte à

amener un réactif d'indium dans un processus EOMPV selon un débit massique réglé, dans lequel le procédé comprend les étapes consistant à:

(a) amener un flux gazeux comprenant un gaz porteur et de la triméthylamine à une pression partielle réglée;
(b) amener un additif solide de triméthyle d'indium et de diphos dans un réservoir qui est relié au flux gazeux par un trajet de diffusion, ledit réservoir et ledit trajet étant maintenus thermostatiquement à une température comprise dans la plage située entre 75 °C et le point de fusion du diphos;
(c) provoquer la diffusion de la triméthylamine dans le réservoir selon un débit massique réglé par sa pression partielle dans le flux gazeux;
(d) amener la triméthylamine située dans le réservoir à réagir avec la vapeur de triméthyle d'indium également située dans le réservoir pour former un complexe triméthylamine/triméthyle d'indium;
(e) amener ledit complexe d'amine à diffuser dans le flux gazeux; grâce à quoi le complexe indium/amine passe dans le procédé EOMPV selon un débit massique réglé par la pression partielle de vapeur de la triméthylamine dans le flux gazeux.

Fig.1.